(19) Europäisches Patentamt

European Patent Office

Office européen des brevets

(11) **EP 1 643 277 A1**

(12) **EUROPEAN PATENT APPLICATION**

(43) Date of publication:
05.04.2006 Bulletin 2006/14

(51) Int Cl.:
*G02B 5/20* (2006.01)   *G09G 3/00* (2006.01)
*G02B 5/22* (2006.01)   *G02B 5/28* (2006.01)
*G02B 1/11* (2006.01)

(21) Application number: 05256080.2

(22) Date of filing: 29.09.2005

(84) Designated Contracting States:
AT BE BG CH CY CZ DE DK EE ES FI FR GB GR
HU IE IS IT LI LT LU LV MC NL PL PT RO SE SI
SK TR
Designated Extension States:
AL BA HR MK YU

(30) Priority: 29.09.2004 JP 2004284880

(71) Applicant: **Fujitsu Hitachi Plasma Display Limited**
**Takatsu-ku**
**Kawasaki-shi**
**Kanagawa (JP)**

(72) Inventors:
• **Kawanami, Yoshima,**
**c/o Fujitsu Hitachi Plasma D. L**
**Kawasaki-shi,**
**Kanagawa (JP)**

• **Hirota, Takatoshi,**
**c/o Fujitsu Hitachi Plasma D. L**
**Kawasaki-shi,**
**Kanagawa (JP)**
• **Hori, Nobuyuki,**
**c/o Fujitsu Hitachi Plasma D. L**
**Kawasaki-shi,**
**Kanagawa (JP)**

(74) Representative: **Fenlon, Christine Lesley**
**Haseltine Lake,**
**Imperial House,**
**15-19 Kingsway**
**London WC2B 6UD (GB)**

(54) **Display filter**

(57)    A display filter is provided that can realize price reduction without lowering electromagnetic wave shielding ability and near infrared rays shielding ability. A conductive mesh is used for shielding electromagnetic waves. A multilayered film (316) and a coloring layer (313) are used for shielding near infrared rays. The multilayered film (316) reflects near infrared rays selectively and the coloring layer (313) absorbs near infrared rays selectively. The use of the multilayered film (316) significantly reduces near infrared rays absorption ability that is required for the coloring layer (313) compared to the case where no multilayered film (316) is used.

FIG. 4

EP 1 643 277 A1

**Description**

BACKGROUND OF THE INVENTION

1. Field of the Invention

The present invention relates to display filters for shielding electromagnetic waves and near infrared rays both of which are emitted by displays. The present invention is suitable for plasma display panels that are one type of flat panel displays.

2. Description of the Related Art

Plasma display panels each incorporate an electromagnetic wave shield and an optical filter therein as EMI countermeasures. The electromagnetic wave shield serves to shield electromagnetic waves that are generated by applying drive voltage. The optical filter (hereinafter referred to as an NIR filter) serves to shield near infrared rays that are emitted by a discharge gas. Japanese Patent No. 3145309, for example, discloses a structure in which an electromagnetic wave shield made up of a transparent conductive film and an NIR filter made up of a multilayered film are formed on a front face of a plasma display panel.

The use of metal mesh as electromagnetic wave shields has recently become common. Since the metal mesh is superior to transparent conductive films in electric conductivity, it is suitable for providing sufficient shielding function in large screens. The metal mesh, however, is incapable of shielding near infrared rays sufficiently, because it has no selectivity in translucent wavelength. Japanese Patent No. 3480898 describes a specific example of the metal mesh.

NIR filters for shielding near infrared rays sufficiently in a selective manner can be realized by coloring matters having desired light absorption properties. When the NIR filters are used in combination with coloring matters that absorb visible lights, a color filter function can be given to the NIR filters. Japanese Unexamined Patent Publication No. 2002-123180 describes a specific example of coloring matters suitable for the NIR filters.

A content of a coloring matter determines near infrared rays shielding ability of an NIR filter including a coloring film. It is necessary to increase the content of the coloring matter in order to improve performance. A problem arises, however, in which the improvement in performance of an NIR filter increases a production cost significantly, since a coloring matter that absorbs near infrared rays selectively is expensive.

SUMMARY OF THE INVENTION

Accordingly, it is desirable to realize a low cost without lowering electromagnetic wave shielding ability and near infrared rays shielding ability. It is also desirable to enhance the near infrared rays shielding ability without lowering the electromagnetic wave shielding ability and raising price.

According to an embodiment of the present invention, conductive mesh is used for shielding electromagnetic waves, and a multilayered film and a coloring layer are used in combination with each other for shielding near infrared rays. The mulilayered film attenuates near infrared rays selectively and the coloring layer absorbs near infrared rays selectively. The use of the multilayered film significantly lowers near infrared rays absorption ability required for the coloring layer in comparison to the case where no multilayered film is used. This is because near infrared rays transmittance of a filter is a product of transmittance in the coloring layer and transmittance in the multilayered film, not simply because the multilayered film compensates for a lowered part of the near infrared rays absorption ability in the coloring layer. Using the multilayered film can reduce coloring matter usage.

According to an embodiment of the present invention, it is possible to realize price reduction of a filter without lowering electromagnetic wave shielding ability and near infrared rays shielding ability.

BRIEF DESCRIPTION OF THE DRAWINGS

Fig. 1 shows an appearance of a display device according to an embodiment of the present invention.
Fig. 2 shows a structure of a display panel device.
Fig. 3 shows an example of a structure of the display device.
Fig. 4 shows a layer structure of a front sheet.
Figs. 5A-5C show a general outline of filter characteristics according to an embodiment of the present invention.
Fig. 6 is a graph showing a relationship between a coloring matter concentration and transmittance.

DESCRIPTION OF THE PREFERRED EMBODIMENTS

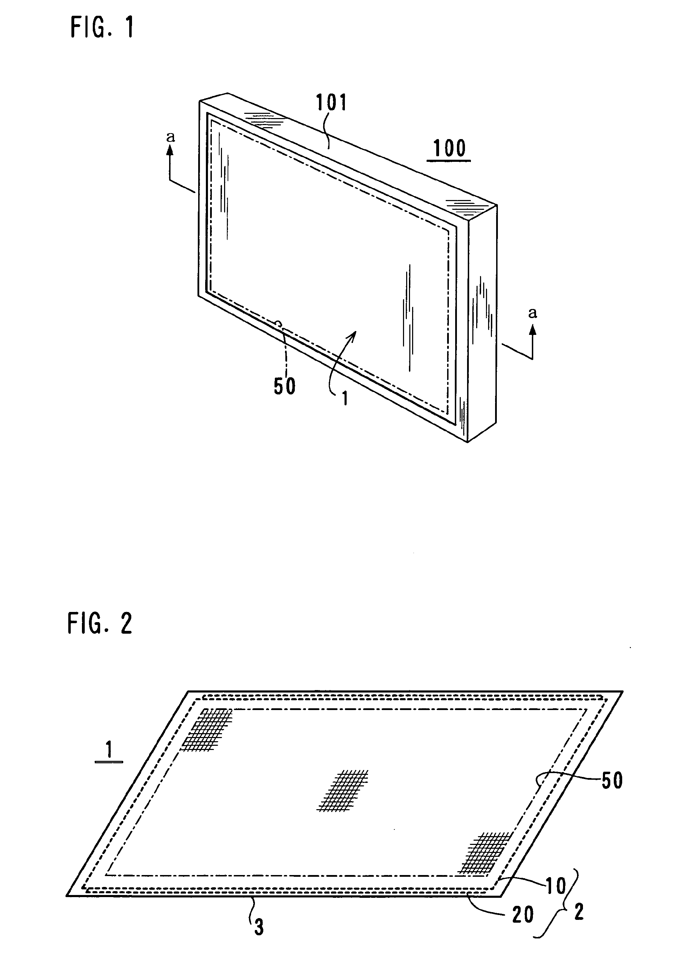

Fig. 1 shows an appearance of a display device according to an embodiment of the present invention. A display device 100 is a flat type display having a 32-inch diagonal screen 50. Dimensions of the screen 50 are 0.72 meters in the horizontal direction and 0.40 meters in the vertical direction. A facing cover 101 that defines a plane size of the display device 100 has an opening that is larger than the screen 50, so that a front face of a display panel device 1 is exposed partly.

Fig. 2 shows a structure of the display panel device. The display panel device 1 includes a plasma display panel 2 that is a device that constitutes a screen and a front sheet 3 that is glued directly on the front face of the plasma display panel 2 to be a display face. The front sheet 3 is a sheet-like structure including a display filter according to an embodiment of the present invention. The plasma display panel 2 is a self-luminous type device that emits light by gas discharge, which includes a front face plate 10 and a rear face plate 20. Each of the front face plate 10 and the rear face plate 20 is a structural element having a base of a glass plate having a thickness of approximately 3 mm.

The plasma display panel 2 is filled with a Penning gas that is a mixture of neon and xenon (equal to or more than 2 %) as a discharge gas. This Penning gas emits near infrared rays having a wavelength of 830 nm and a wavelength of 880 nm at discharge.

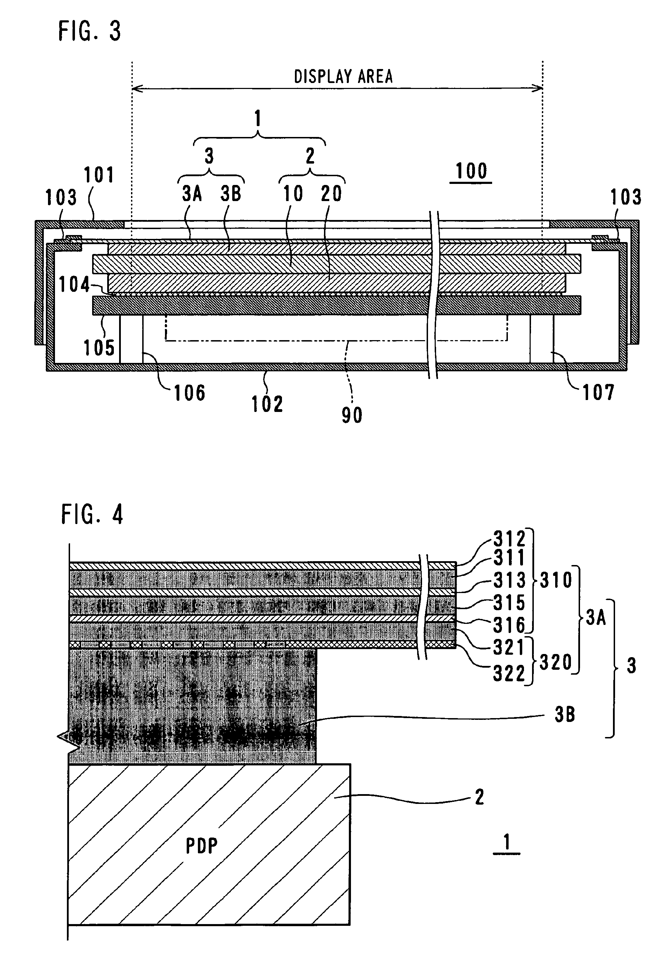

Fig. 3 is a cross-sectional cut along a-a line in Fig. 1 and shows a structure of the display device. The display device 100 includes a display panel device 1 arranged in a conductive housing 102 to which the facing cover 101 is attached. The display panel device 1 is attached to a chassis 105 made of aluminum via a thermal conducting adhesive tape 104, and the chassis 105 is fixed to the conductive housing 102 via spacers 106 and 107. A driving circuit 90 is arranged on the rear side of the chassis 105. A power source, a video signal processing circuit and an audio circuit are omitted in Fig. 3.

The front sheet 3 is a flexible layered film including a front portion 3A having a thickness of 0.3 mm whose base is a resin film and a rear portion 3B having a thickness of approximately 0.5 mm made of a resin layer that are put on each other, which will be described later. In particular, the thin front portion 3A that is a functional film having a multilayered structure has a good flexibility. The plane size of the front sheet 3, more specifically the plane size of the front portion 3A is larger than the plane size of the plasma display panel 2, so that the peripheral portion of the front portion 3A is positioned outside the plasma display panel 2. The plane size of the rear portion 3B is smaller than that of the front portion 3A and larger than that of the screen.

The conductive housing 102 is a metal plate formed in a boxed shape having a rectangular rear face, four side faces and a looped front face. The conductive housing 102 is also a conductive member that covers the side faces and the rear face of the plasma display panel 2 with being spaced apart therefrom. Inner rim of the front face of the conductive housing 102 is placed outside the plasma display panel 2 as viewed from the front.

In the display device 100, the front sheet 3 extends along the plasma display panel 2 substantially in flat, and only the end portion thereof contacts the front face of the conductive housing 102. A looped pressure member 103 is disposed in front of the front sheet 3, which is sandwiched between the pressure member 103 and the front face of the conductive housing 102 so that the end portion of the front sheet 3 is fixed to the conductive housing 102. Here, the front portion 3A includes an electromagnetic wave shielding layer 320 having a function of preventing halation. The electromagnetic wave shielding layer 320 is a rear side layer of the front portion 3A. A plane size of the front portion 3A is the same as that of the front sheet 3 and is larger than that of the rear portion 3B. Accordingly, when the front sheet 3 is fixed to the conductive housing 102, the electromagnetic wave shielding layer 320 is connected to the conductive housing 102 electrically. The connection position thereof is away from the plasma display panel 2.

Fig. 4 shows a layer structure of the front sheet. The front sheet 3 is a layered film having a thickness of approximately 0.8 mm including an optical film layer 310 having a thickness of 0.2 mm, an electromagnetic wave shielding layer 320 having a thickness of 0.1 mm and the rear portion 3B that is an adhesive layer having an impact absorbing function with a thickness of approximately 0.5 mm. The optical film layer 310 and the electromagnetic wave shielding layer 320 constitute the front portion 3A, and the plane sizes of them are the same. A visible light transmittance of the entire front sheet 3 is approximately 40% after spectral luminous efficiency correction. A weight of the front sheet 3 is approximately 500 grams, so the front sheet 3 is much lighter than a previously-proposed filter plate (approximately 2.5 kilograms) for 32-inch screen.

The optical film layer 310 includes a film 311 made of PET (polyethylene terephthalate), an anti-reflection film 312 that is coated on the front side of the film 311, a coloring layer 313 that is formed on the rear side of the film 311, a film 315 and a multilayered film 316, which is unique to an embodiment of the present invention, formed on the rear side of the film 315.

The anti-reflection film 312 prevents reflection of external light. The function of the anti-reflection film 312, however, may be changed from AR (anti reflection) to AG (anti glare). The anti-reflection film 312 includes a hard coat for increasing scratch resistance of the surface of the sheet up to pencil hardness 4H.

The coloring layer 313 adjusts visible light transmittance of red (R), green (G) and blue (B) for a color display and cuts off near infrared rays. The coloring layer 313 contains in a resin an infrared absorption coloring matter for absorbing light having a wavelength within the range between approximately 800 and 1000 nm, a neon light absorption coloring matter for absorbing light having a wavelength of approximately 580 nm and a coloring matter for adjusting visible light transmittance. An external light reflection factor of the optical film layer 310 is 3% after the spectral luminous efficiency correction, and the visible light transmittance is 55% after the spectral luminous efficiency correction. In addition, near infrared rays transmittance is 10% as an average in an absorption wavelength range.

The multilayered film 316 cuts off near infrared rays. The multilayered film 316 is a layered film that is formed by sputtering a dielectric material and metal (silver, for example) alternately or others. The multilayerd film 316 reflects near infrared rays having a wavelength within the range between approximately 800 and 1000 nm by multiple interference. Near infrared rays transmittance in the multilayered film 316 is 40% as an average in the wavelength range between approximately 800 and 1000 nm.

Variations of the structure of the multilayered film 316 include a laminate of a dielectric material having a low refractive index such as $MgF_2$, $SiO_2$, or the like and a dielectric material having a high refractive index such as $ZrO_2$, $Ta_2O_5$, $TiO_2$ or the like. The laminate of metal and a dielectric material is advantageous in that the number of layers is reduced, since it can increase the dielectric constant difference. In particular, silver is a suitable material since it has a function of absorbing near infrared rays.

The electromagnetic wave shielding layer 320 includes a film 321 made of PET and a conductive layer 322 having a thickness of 10 microns that is a copper foil with a mesh portion. The visible light transmittance of an area of the conductive layer 322 that overlaps the screen is 80%. As the front surface of the conductive layer 322 is black, the electromagnetic wave shielding layer 320 looks substantially coal-black when it is viewed through the optical film layer 310.

The films 311 and 315 of the optical film layer 310 and the film 321 of the electromagnetic wave shielding layer 320 have a function of preventing a glass plate of the plasma display panel 2 from scattering when the glass plate is broken in an abnormal situation. In order to realize this function, it is preferable that a total thickness of the films 311 and 315 and the film 321 is 50 microns or more. In this example, a total sum of the thickness of the PET is equal to or more than 150 microns.

The adhesive layer as the rear portion 3B is made of a soft resin of an acrylic system, and a visible light transmittance thereof is 90%. The adhesive layer (3B) is formed by applying the resin. When the resin is applied, it enters spaces of the mesh of the conductive layer 322, so that the conductive layer 322 is flattened. Thus, scattering of light due to unevenness of the conductive layer 322 can be prevented.

In this example, the adhesive layer (3B) has an impact absorbing function. The adhesive layer (3B) has relatively strong adhesiveness to the electromagnetic wave shielding layer 320 made of PET and copper. On the contrary, the adhesive layer (3B) has loose adhesiveness to the glass surface that is the front face of the plasma display panel 2. The adhesion force thereof is approximately 2N/25 mm. When the front sheet 3 is peeled, the front portion 3A is not separated from the rear portion 3B so that the front sheet 3 is separated from the plasma display panel 2 normally. "Normally" means that an even peeled surface without a visible remaining matter can be obtained.

The sufficient thickness of the rear portion 3B constituted by the adhesive layer 351 contributes to improvement in productivity of plasma display panel modules. The plasma display panel module in the present embodiment is the plasma display panel 2 where a driving circuit is incorporated and the front sheet 3 is glued and means a half-finished product that is accommodated in the conductive housing 102 in the display device 100 shown in Fig. 3.

In manufacture of plasma display panel modules, foreign matters may be mixed in a bonding interface when a front sheet is glued on the plasma display panel 2. If the rear portion 3B constituted by the adhesive layer has a thickness similar to the size of the foreign matter, air bubbles appear around the foreign matter. Accordingly, the front sheet needs to be glued in a clean room in order to avoid the mixing of foreign matters. In such a case, however, the front sheet is glued on the plasma display panel prior to an aging test and a lighting test of the plasma display panel. In the event that the plasma display panel is determined to be defective after the lighting test, the front sheet is waste in addition to the plasma display panel. Even if the front sheet has a peelable and reproducible structure, a process for peeling the front sheet is added.

In contrast, even when a foreign matter having a size of approximately a few tens of microns is mixed, no air bubbles appear, provided that the rear portion (adhesive layer) 3B has a thickness equal to or more than 100 microns (preferably, 200 microns through 500 microns = 0.2 mm thorough 0.5 mm). This is because the foreign matter buries in the soft rear portion 3B. Accordingly, a chassis for heat dissipation and a driving circuit are incorporated in the plasma display panel 2 and a lighting test is performed. Then, the front sheet 3 is glued on the plasma display panel 2 that passed the lighting test. This can eliminate time loss and resource loss such as a front sheet that is discarded or peeled.

In addition, a material having good wettability to glass that is a base material of the front face plate of the plasma display panel is used as a material for the adhesive layer. This can prevent the appearance of air bubbles due to foreign matters even under decompression environment in uplands (3000 meters above sea level, for example).

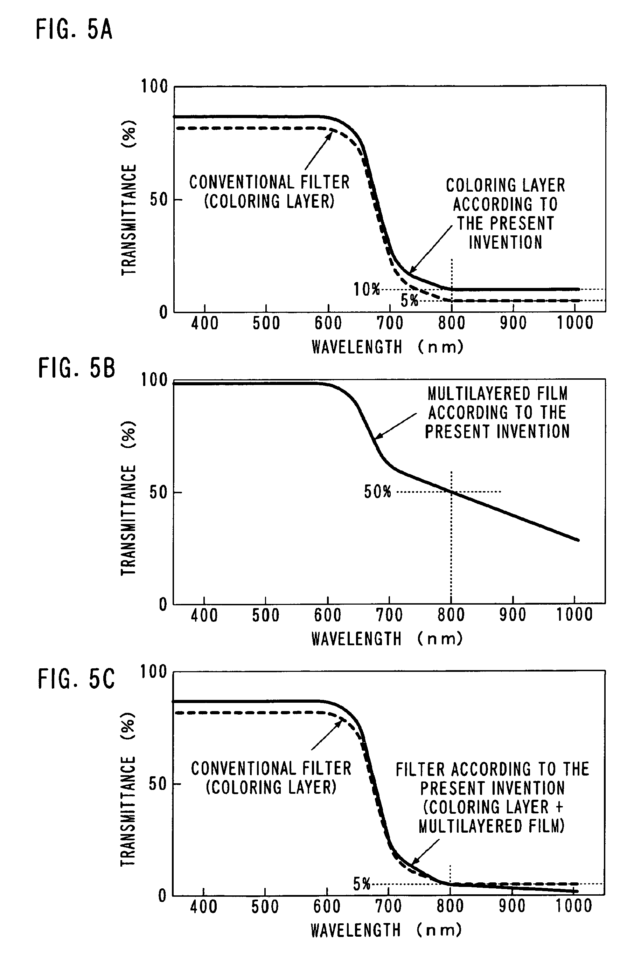

Figs. 5A-5C show a general outline of filter characteristics according to an embodiment of the present invention.

Fig. 5A shows characteristics of the coloring layer 313. The average transmittance of light having a predetermined wavelength range between 800 and 1000 nm is 10% in the coloring layer 313. The average transmittance does not satisfy a value of 5% that is a specification of near infrared rays absorption ability. In comparison to previously-proposed filters that satisfy specifications, a content of the coloring matter is reduced in the coloring layer 313, which reduces the near infrared rays absorption ability by design. The purpose of the reduction is to make the coloring layer 313 inexpensive.

Fig. 5B shows characteristics of the multilayered film 316. The transmittance of light having a wavelength range between 800 and 1000 nm is equal to or less than 50% in the multilayered film 316.

Fig. 5C shows characteristics of a filter according to an embodiment of the present invention, i.e., a layered film of the coloring layer 313 and the multilayered film 316. The transmittance of light having a noted wavelength in the filter is a product of the transmittance of such light in the coloring layer 313 and the transmittance of such light in the multilayered film 316. More specifically, even when the transmittance in the coloring layer 313 is 10%, the transmittance in the multilayered film 316 is equal to or less than 50%. Accordingly, the transmittance of light having a wavelength range between 800 and 1000 nm in the filter is equal to or less than 5%, so that specifications are satisfied.

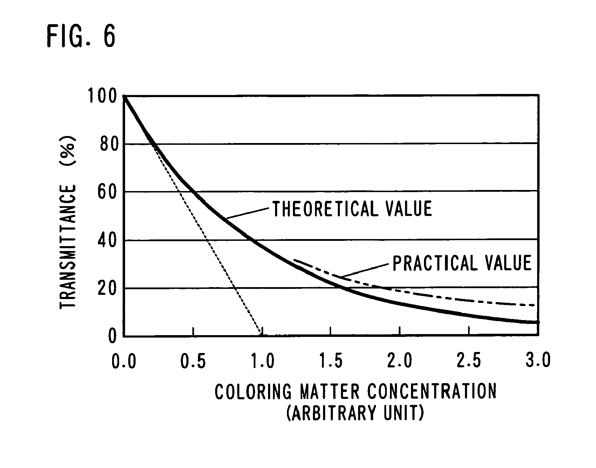

Fig. 6 is a graph showing a relationship between a coloring matter concentration and transmittance.

Suppose that an amount of the coloring matter is denoted by M, transmittance T of light having a certain wavelength is defined as the following equation.

$$T = \exp(-aM)$$

where a is a coefficient representing absorption ability.

When M is a small value, T can approximate 1-aM ($T \fallingdotseq 1$-aM). The transmittance decreases linearly with increasing a value of M. However, saturation is gradually reached as a value of T approaches zero.

Suppose that M necessary for making the transmittance 10% is 1. The value of M needs to be 1.3 in order to make the transmittance 5%. In other words, it is necessary to increase the coloring matter by 30%. More specifically, when absorption ability is reduced from the transmittance of 5% to the transmittance of 10%, reduction from 1.3 to 1, i.e., 23 percent reduction of the coloring matter amount (cost reduction) is expected. In practice, the relationship between the coloring matter concentration and the transmittance is looser than theoretical values due to ununiformness of coloring matter distribution, leading to a substantial cost reduction effect.

In the present embodiment, the coloring layer 313 and the multilayered film 316 are superimposed one over the other to constitute the NIR filter. Accordingly, a filter having high ability of shielding near infrared rays can be easily realized in comparison to a case where the NIR filter is made up of only the coloring layer or of only the multilayered film.

The performance of the multilayered film is enhanced with increasing the number of layers. Increasing the number of layers, however, raises a production cost. Accordingly, it is necessary to design the coloring layer 313 and the multilayered film 316 so that the cost reduction due to the reduction of the coloring matter amount in the coloring layer 313 exceeds the cost increase due to the use of the multilayered film 316.

An arrangement position of the multilayered film 316 is closer to the plasma display panel 2 compared to the 0 coloring layer 313. This arrangement substantially reduces reflection of red components of external light from the multilayered film 316 compared to another arrangement where the multilayered film 316 is placed ahead of the coloring matter 313. Accordingly, the former arrangement is preferred to the latter arrangement in that neutrality of appearance color of the front sheet 3 is maintained.

In this embodiment described above, the structure is exemplified in which a filter is provided in the front sheet 3 that is directly glued on the front face plate of the plasma display panel 2. In a structure where a protection plate is arranged in front of the plasma display panel 2, the filter may be glued on the protection plate.

An embodiment of the present invention contributes to provision of inexpensive display filters for shielding electromagnetic waves and near infrared rays both of which are emitted by displays.

While example embodiments of the present invention have been shown and described, it will be understood that the present invention is not limited thereto, and that various changes and modifications may be made by those skilled in the art without departing from the scope of the invention.

## Claims

1. A display filter comprising:

   a conductive mesh for shielding an electromagnetic wave;
   a multilayered film for reflecting near infrared rays selectively; and
   a coloring layer for absorbing the near infrared rays selectively,

   wherein the conductive mesh, the multilayered film and the coloring layer are laminated together.

2. The display filter according to claim 1, wherein transmittance of near infrared rays having a wavelength of 830 nm and of near infrared rays having a wavelength of 880 nm is equal to or less than 5%.

3. The display filter according to claim 1 or 2, wherein the multilayered film is a layered film of plural dielectric layers each of which has a different refractive index for the near infrared rays.

4. The display filter according to claim 1, 2 or 3, wherein the multilayered film is a layered film of a dielectric and metal.

5. The display filter according to claim 1, 2, 3 or 4, wherein the multilayered film is placed on a rear side of the coloring layer.

6. A display panel device, comprising:

   a plasma display panel; and

a translucent front sheet that is glued on a front face of the plasma display panel,

wherein the front sheet includes a conductive mesh for shielding an electromagnetic wave, a coloring layer for absorbing near infrared rays selectively, and a multilayered film for attenuating the near infrared rays selectively.

7. The display panel device according to claim 6, further comprising an adhesive layer for bonding the front sheet and the plasma display panel together.

8. The display panel device according to claim 7, wherein the adhesive layer has a thickness equal to or more than 100 microns.

FIG. 1

FIG. 2

FIG. 3

DISPLAY AREA

FIG. 4

PDP

FIG. 5A

FIG. 5B

FIG. 5C

## FIG. 6

**European Patent Office**

**EUROPEAN SEARCH REPORT**

Application Number

EP 05 25 6080

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 267 318 A (MITSUI CHEMICALS, INC) 18 December 2002 (2002-12-18) * the whole document * ----- | 1-8 | G09G3/00 G02B5/20 G02B5/22 G02B5/28 G02B1/11 |
| A | US 2003/094296 A1 (KOJIMA HIROSHI ET AL) 22 May 2003 (2003-05-22) * paragraph [0009] - paragraph [0017] * ----- | 1,6 | |
| X | US 6 469 685 B1 (WOODRUFF DANIEL P ET AL) 22 October 2002 (2002-10-22) * column 4 * * column 8, line 59 - column 9, line 18 * ----- | 1,6 | |
| X | US 6 067 188 A (ZIEBA ET AL) 23 May 2000 (2000-05-23) * column 3, line 30 - line 44 * ----- | 1,6 | |
| A | WO 2004/066342 A (SKC LIMITED; CHO, KYOOCHOONG; PARK, CHANHONG; PARK, JINBUM) 5 August 2004 (2004-08-05) * page 1 - page 4 * ----- | 1-8 | TECHNICAL FIELDS SEARCHED (IPC) G09G G02B |

The present search report has been drawn up for all claims

| Place of search | Date of completion of the search | Examiner |
|---|---|---|
| Munich | 5 January 2006 | Feeney, O |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

...............................................................................

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 05 25 6080

This annex lists the patent family members relating to the patent documents cited in the above-mentioned European search report.
The members are as contained in the European Patent Office EDP file on
The European Patent Office is in no way liable for these particulars which are merely given for the purpose of information.

05-01-2006

| Patent document cited in search report | | Publication date | Patent family member(s) | | Publication date |
|---|---|---|---|---|---|
| EP 1267318 | A | 18-12-2002 | CN<br>WO<br>US | 1397057 A<br>0157833 A1<br>2003156080 A1 | 12-02-2003<br>09-08-2001<br>21-08-2003 |
| US 2003094296 | A1 | 22-05-2003 | TW | 558940 B | 21-10-2003 |
| US 6469685 | B1 | 22-10-2002 | AU<br>CA<br>EP<br>JP<br>WO | 8166198 A<br>2295236 A1<br>0992032 A1<br>2002507288 T<br>9859335 A1 | 04-01-1999<br>30-12-1998<br>12-04-2000<br>05-03-2002<br>30-12-1998 |
| US 6067188 | A | 23-05-2000 | NONE | | |
| WO 2004066342 | A | 05-08-2004 | NONE | | |

EPO FORM P0459

For more details about this annex : see Official Journal of the European Patent Office, No. 12/82